# EUROPÄISCHE PATENTSCHRIFT

(11) **EP 0 236 799 B1**
(45) Veröffentlichungstag und Bekanntmachung des Hinweises auf die Patenterteilung: **23.06.1993**
(21) Anmeldenummer: 87102208.3
(22) Anmeldetag: 17.02.1987
(51) Int. Cl.: H05K 7/14, H05K 7/18

(54) **Baugruppenträger für elektronische und/oder elektromechanische Einschubbaugruppen**
Assembly support for electronic or electromechanical plug-in-panel assemblies
Support pour ensembles électroniques ou électromécaniques à tiroirs connectables

(30) Priorität: 11.03.1986 DE 3608046
(43) Veröffentlichungstag der Anmeldung: 16.09.1987
(73) Patentinhaber: Siemens Nixdorf Informationssysteme Aktiengesellschaft, 33102 Paderborn (DE)
(72) Erfinder: Heuing, Norbert, D-4790 Paderborn (DE); Scharnetzke, Rainer, D-4792 Bad Lippspringe (DE); Knoop, Franz-Josef, D-4793 Büren-Steinhausen (DE)
(74) Vertreter: Fuchs, Franz-Josef, Dr.-Ing.

(56) Entgegenhaltungen:
- EP-A- 0 220 677
- DE-B- 1 302 591
- FR-A- 2 184 443
- GB-A- 1 313 641
- US-A- 4 472 765
- US-A- 4 502 100
- ELECTRO AND MINI/MICRO NORTHEAST, 23.-25. April 1985, Seiten 1-6, New York, US; P.R. BERKOWITZ et al.: "A distributed power architecture for the system 75 digital communications system"

## Beschreibung

Die Erfindung betrifft einen Baugruppenträger für elektronische und/oder elektromechanische Baugruppen, die an ihren in Einschubrichtung weisenden Rändern Kontaktelemente zum Einstecken in auf einer Verbindungsplatine befestigte Stecker aufweisen, wobei die Baugruppen an zwei nach entgegengesetzten Richtungen weisenden Seiten des Baugruppenträger in diesen einschiebbar sind und wobei die auf ihren beiden Seiten Stecker tragende Verbindungsplatine zwischen den Einschuböffnungen der Baugruppenträgers angeordnet ist.

Ein Baugruppenträger der vorstehend genannten Art ist aus der nicht vorveröffentlichten EP-A-0 220 677 bekannt. Bei der bekannten Anordnung sind beiderseits der Verbindungsplatine zwei Stapel von die Baugruppen bildenden Schaltungsplatinen vorgesehen, wobei die Schaltungsplatinen des einen Stapels senkrecht zu den Schaltungsplatinen des anderen Stapels gerichtet sind. Ziel dieser Anordnung ist es, jeden Verkabelungsaufwand zu vermeiden.

Die DE-B-1 302 591 beschreibt einen Baugruppenträger für elektronische und/oder elektromechanische Einschubbaugruppen, die an ihren in Einschubrichtung weisenden Rändern Kontaktelemente zum Einstecken in auf einer Verbindungsplatine befestigte Stecker aufweisen, wobei die Baugruppen an zwei in entgegengesetzte Richtungen weisenden Seiten des Baugruppenträgers in diesen einschiebbar sind. In der Mitte zwischen den Einschuböffnungen des Baugruppenträgers sind zwei Verbindungsplatinen vorgesehen, die durch Abstandselemente voneinander getrennt sind, so daß also jeder von einer Seite des Baugruppenträgers her einschiebbaren Gruppe von Schaltungsplatinen eine Verbindungsplatine zugeordnet ist.

Der Erfindung liegt die Aufgabe zugrunde, einen Baugruppenträger der eingangs genannten Art anzugeben, der eine sehr kompakte Anordnung der Baugruppen erlaubt, d.h. bei einer gegebenen Anzahl von Baugruppen geringe Außenabmessungen aufweist und bei dem sich mit einem geringen Verdrahtungsaufwand sehr kurze Leitungswege zwischen den einzelnen Baugruppen ergeben.

Diese Aufgabe wird dadurch gelöst, daß die zur Aufnahme von Baugruppen bestimmten Schiebeführungen und die Stekker auf der einen Seite der Verbindungsplatine gegenüber gleichartigen Schiebeführungen bzw. Steckern auf der anderen Seite der Verbindungsplatine quer zur Einschubrichtung versetzt angeordnet sind.

Bei der erfindungsgemäßen Lösung ergeben sich sehr kurze Leitungswege zwischen den einzelnen Baugruppen. Kabelverbindungen zwischen den Baugruppen können entfallen, da sämtliche Verbindungen über die Verbindungsplatine geführt sind. Wenn der Baugruppenträger zur Aufnahme von Systemmodulen einer Datenverarbeitungsanlage bestimmt ist, bedeutet dies, daß auf einer sehr geringen Sammelleitungs- oder Buslänge eine große Anzahl von Systemmodulen plaziert werden kann. Aufgrund der geringen Buslänge können die Systemmodulen über einfache Schnittstellenbausteine angeschlossen werden, da bei der geringen Buslänge die Laufzeiten der Signale auf dem Bus geringer sind als der zeitliche Abstand zweier aufeinander folgender Signale. Durch die versetzte Anordnung der Stecker und Schiebeführungen beiderseits der Verbindungsplatine können bestimmte Baugruppen wahlweise von der einen oder von der anderen Seite her in dem Baugruppenträger eingeschoben werden. Dies erlaubt ferner eine besonders kompakte Anordnung der Baugruppen und eine dichte Packung der dazugehörigen Stecker sowie eine weitere Verkürzung der Verbindungsleitungen auf der Verbindungsplatine. Der Wegfall des Verdrahtungsaufwandes bedeutet nicht nur eine Senkung der Herstellungskosten, sondern auch eine erhöhte Störsicherheit der Geräte.

Vorzugsweise weist der Baugruppenträger eine quer zur Einschubrichtung der Baugruppen gerichtete Schiebeführung zum Einschieben der Verbindungsplatine auf. Das erlaubt eine einfache Bestückung des Baugruppenträgers. Zunächst wird die Verbindungsplatine in den Baugruppenträger eingeschoben und an diesem durch Schrauben, Rastelemente oder dergleichen befestigt. Anschließend können die Baugruppen in den Baugruppenträger eingeschoben und durch Steckverbindungen mit der Verbindungsplatine elektrisch verbunden werden.

Eine bevorzugte Ausführungsform des Baugruppenträgers weist zumindest zwei übereinanderliegende Etagen zum Einschub von Baugruppen auf. Dies ist insbesondere für Datenverarbeitungsgeräte von Vorteil, die neben dem Arbeitsplatz aufgestellt werden und daher nur eine geringe Grundfläche benötigen sollen. Vorzugsweise ist dabei allen Etagen des Baugruppenträgers eine gemeinsame Verbindungsplatine zugeordnet, so daß Verdrahtungen zwischen den Etagen entfallen können.

Um bei der kompakten Anordnung der Baugruppen eine ausreichende Kühlung derselben zu erreichen, ist es von Vorteil,wenn mindestens zwischen zwei Etagen mit elektronischen oder elektromechanischen Baugruppen eine Etage zur Aufnahme einer Lüftereinheit vorgesehen ist, die ebenfalls an die Verbindungsplatine ansteckbar ist. Durch die Anordnung der Lüftereinheit zwischen den Etagen von Baugruppen entfallen Luftzuführungskanäle. Gleichzeitig wird das durch die Lüftung verursachte Geräusch gemindert. Vorzugsweise ist die zur Steuerung der Lüftereinheit bestimmte elektronische Steuerschaltung auf der Verbindungsplatine angeordnet, wobei mindestens Teile der elektrischen Steuerschaltung allen Lüftereinheiten gemeinsam sein können.

Bei einer bevorzugten Ausführungsform der Erfindung weist der Baugruppenträger an seinem oberen Ende eine Lufteintrittsöffnung und nahe seinem unteren Ende eine Luftaustrittsöffnung auf, so daß der Lüftungsstrom von unten nach oben durch die Baugruppen geleitet wird. Dies hat den Vorzug, daß der bodennahe Staub nicht in das Gerät eingesaugt wird und daß eine Belästigung von Personen durch einen nach oben aus einem Gerät austretenden Luftstrom vermieden wird.

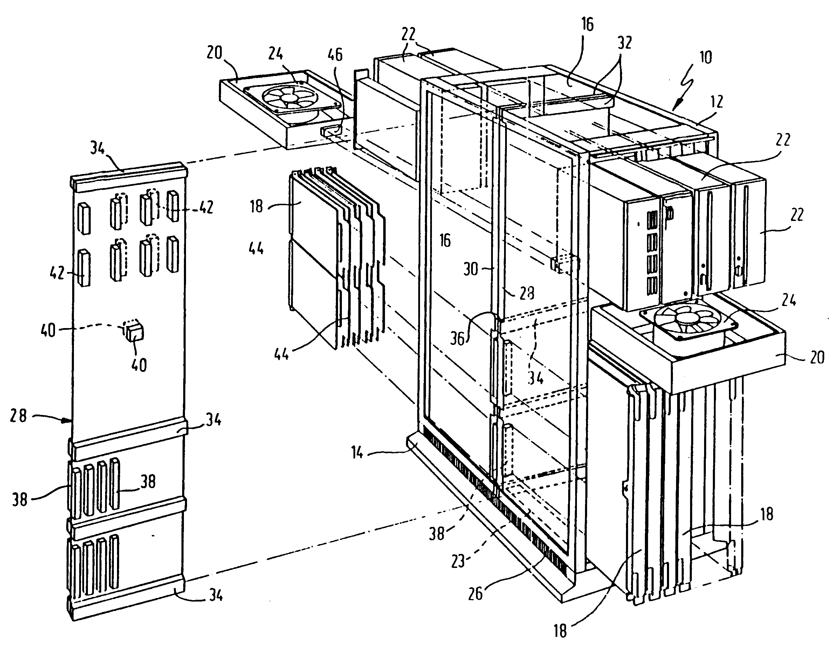

Weitere Merkmale und Vorteile der Erfindung ergeben sich aus der folgenden Beschreibung, welche in Verbindung mit der beigefügten Zeichnung die Erfindung anhand eines Ausführungsbeispieles erläutert. Die einzige Figur zeigt eine teilweise schematische perspektivische Explosionsdarstellung eines erfindungsgemäßen Baugruppenträgers.

Der in der Figur dargestellte allgemein mit 10 bezeichnete Baugruppenträger umfaßt einen quaderförmigen aus Profilen bestehenden Rahmen 12, der hochkant auf einem Sockel 14 steht und an seinen vertikalen Breitseiten jeweils durch eine Wand 16 verschlossen ist. An den vertikalen Schmalseiten ist der Rahmen 12 dagegen offen zum Einschieben von Baugruppen 18, 20 und 22, die in drei Etagen übereinander angeordnet sind. Für das Einschieben der Baugruppen 18 bis 22 ist der Rahmen 12 jeweils mit Schiebeführungen versehen, die an sich bekannt und daher auch nur bei 23 angedeutet sind. Bei dem dargestellten Ausführungsbeispiel sind die Baugruppen 18 in der untersten Etage des Baugruppenträgers 10 von Schaltungsplatinen einer elektronischen Datenverarbeitungseinrichtung gebildet. In der obersten Etage des Baugruppenträgers 10 sind die Baugruppen 22 von Peripheriegeräten wie beispielsweise Plattenlaufwerken der Datenverarbeitungsanlage gebildet. Zwischen den Baugruppen 18 und 22 ist in der mittleren Etage eine Lüftereinheit 20 mit einem Axiallüfter 24 eingeschoben, der Luft durch das obere offene Ende des Rahmens 12 ansaugt, wobei diese die Baugruppen 22 durchströmt und kühlt, und anschließend die angesaugte Luft durch die Baugruppen 18 bläst, bis sie durch Lüftungsschlitze 26 im Sockel 14 austritt.

Zur elektrischen Verbindung der einzelnen Baugruppen 18, 22 untereinander bzw. mit einem Netzgerät oder dergleichen dient eine Verbindungsplatine 28, die in der Mitte zwischen den beiden vertikalen Schmalseiten des Rahmens 12 und parallel zu diesen in den Baugruppenträger 10 einschiebbar ist. Heirzu weist eine Seitenwand 16 einen vertikalen Einschubschlitz 30 auf. Ferner sind an der Unterseite und der Oberseite des Rahmens 12 Schiebeführungen 32 zum Einschieben der Verbindungsplatine 28 vorgesehen, von denen in der Figur der Klarheit halber nur die oberen dargestellt sind. Um eine Durchbiegung der Verbindungsplatine 28 zu vermeiden, ist diese auf ihren beiden Seiten mit einer Reihe von Führungsprofilen 34 versehen, die beim Einschieben der Verbindungsplatine 28 in den Einschubschlitz 30 an Flanschen 36 entlanggleiten, die an den Rändern des Einschubschlitzes 30 ausgebildet sind.

Die Verbindungsplatine 28 trägt auf beiden Seiten Steckerleisten 38, 40, 42, in die entsprechende Kontaktelemente 44 bzw. Gegenstecker 46 an den Baugruppen in an sich bekannter Weise einsteckbar sind. Die Schiebeführungen und auch die Steckerleisten 38 beidseits der Verbindungsplatine 28 für die in der untersten Etage des Baugruppenträgers 10 einschiebbaren Schaltungsplatinen sind um den halben Abstand zweier benachbarter Schaltungsplatinen gegeneinander versetzt, wie dies bei den Steckerleisten 38 auf der Verbindungsplatine 28 angedeutet ist. Dadurch erhält man eine sehr kompakte Anordnung der Steckerleisten auf der Verbindungsplatine 28 mit kurzen Leitungswegen und eine dichte Packung der Baugruppen 18.

Da die elektrische Verbindung zwischen den Schaltungsplatinen 18 und den Peripheriegeräten 22 über Leiterbahnen auf der Verbindungsplatine 28 erfolgen kann, entfallen aufwendige Kabelverbindungen. Die elektronische Steuerschaltung für die Lüftereinheiten 20 kann ebenfalls auf der Verbindungsplatine 28 untergebracht sein, so daß auch hier der sonst übliche Verdrahtungsaufwand entfällt.

Es versteht sich, daß der dargestellte Baugruppenträger mit den Einschüben üblicherweise von Gehäusewänden eingeschlossen ist, von denen zumindest die obere Deckfläche Lufteintrittsschlitze aufweist.

## Patentansprüche

1. Baugruppenträger für elektronische und/oder elektromechanische Einschubbaugruppen (18, 20, 22), die an ihren in Einschubrichtung weisenden Rändern Kontaktelemente zum Einstecken in auf einer Verbindungsplatine befestigte Stecker aufweisen, wobei die Baugruppen (18, 20, 22) an zwei nach entgegengesetzten Richtungen weisenden Seiten des Baugruppenträgers (10) in diesen einschiebbar sind und wobei die auf ihren beiden Seiten Stecker (38, 40, 42) tragende Verbindungsplatine (28) zwischen den Einschuböffnungen des Baugruppenträgers (10) angeordnet ist, dadurch **gekennzeichnet,** daß die zur Aufnahme von Baugruppen (18, 20, 22) bestimmten Schiebeführungen (23) und die Stecker (38) auf der einen Seite der Verbindungsplatine (28) gegenüber gleichartigen Schiebeführungen (23) bzw. Steckern (38) auf der anderen Seite der Verbindungsplatine (28) quer zur Einschubrichtung versetzt angeordnet sind.

2. Baugruppenträger nach Anspruch 1, dadurch **gekennzeichnet,** daß er eine quer zur Einschubrichtung der Baugruppen (18, 20, 22) gerichtete Schiebeführung (32) zum Einschieben der Verbindungsplatine (28) aufweist.

3. Baugruppenträger nach Ansprüch 1 oder 2, dadurch **gekennzeichnet,** daß er mindestens zwei übereinanderliegende Etagen zum Einschub von Baugruppen (18, 20, 22) aufweist.

4. Baugruppenträger nach Anspruch 3, dadurch **gekennzeichnet,** daß allen Etagen eine gemeinsame Verbindungsplatine (28) zugeordnet ist.

5. Baugruppenträger nach Anspruch 3 oder 4, dadurch **gekennzeichnet,** daß mindestens zwischen zwei Etagen mit elektronischen und/oder elektromechanischen Baugruppen (18, 22) eine Etage zur Aufnahme einer Lüftereinheit (20) vorgesehen ist, die an die Verbindungsplatine (28) anschließbar ist.

6. Baugruppenträger nach Anspruch 5, dadurch **gekennzeichnet,** daß eine zur Steuerung der Lüftereinheit (20) bestimmte elektronische Steuerschaltung auf der Verbindungsplatine (28) angeordnet ist.

7. Baugruppenträger nach Anspruch 6, dadurch **gekennzeichnet,** daß mindestens Teile der elektronischen Steuerschaltung allen Lüftereinheiten (20) gemeinsam sind.

8. Baugruppenträger nach einem der Ansprüche 5 bis 7, dadurch **gekennzeichnet,** daß er an seinem oberen Ende eine Lufteintrittsöffnung und nahe seinem unteren Ende eine Luftaustrittsöffnung aufweist.

## Claims

1. Mounting rack for electronic and/or electromechanical rack assemblies (18, 20, 22) which have contact elements on their edges pointing in the insertion direction for insertion into a plug which is mounted on an interconnection board, the assemblies (18, 20, 22) being capable of insertion into the mounting rack (10) on two sides of the latter pointing in opposite directions, and the interconnection board (28), which carries plugs (38, 40, 42) on both its sides, being arranged between the insertion openings of the mounting rack (10), characterised in that the sliding guides (23) which are intended for holding the assemblies (18, 20, 22) and the plugs (38) on the one side of the interconnection board (28) are arranged offset at right-angles to the insertion direction with respect to identical sliding guides (23) and plugs (38) on the other side of the interconnection board (28).

2. Mounting rack according to Claim 1, characterised in that it has a sliding guide (32), which is directed at right-angles to the insertion direction of the assemblies (18, 20, 22), for insertion of the interconnection board (28).

3. Mounting rack according to Claim 1 or 2, characterised in that it has at least two tiers, located one above the other, for the insertion of assemblies (18, 20, 22).

4. Mounting rack according to Claim 3, characterised in that a common interconnection board (28) is allocated to all the tiers.

5. Mounting rack according to Claim 3 or 4, characterised in that a tier for holding a fan unit (20) which can be connected to the interconnection board (28) is provided at least between two tiers having electronic and/or electromechanical assemblies (18, 22).

6. Mounting rack according to Claim 5, characterised in that an electronic control circuit which is intended for controlling the fan unit (20) is arranged on the interconnection board (28).

7. Mounting rack according to Claim 6, characterised in that at least parts of the electronic control circuit are common to all the fan units (20).

8. Mounting rack according to one of Claims 5 to 7, characterised in that it has an air inlet opening at its upper end and an air outlet opening close to its lower end.

## Revendications

1. Porte-modules pour des modules électroniques et/ou électromécaniques embrochables (18,20,22), qui possèdent, sur leurs bords dirigés dans la direction d'insertion, des éléments de contact destinés à être enfichés dans des connecteurs fixés sur une platine de connexion, et dans lequel les modules (18,20,22) peuvent être insérés dans le porte-modules (10), sur deux faces de ce dernier, qui sont tournées dans des directions opposées, et la platine de connexion (28), qui porte des connecteurs (38,40,42) sur ses deux faces, est disposée entre les ouvertures d'insertion du porte-modules (10), caractérisé par le fait que des glissières (23) destinées à recevoir des modules (18,20,22) et les connecteurs (38) situés sur une face de la platine de connexion (28) sont disposés en étant décalés par rapport aux glissières (23) et aux connecteurs (38), de même type, situés sur l'autre face de la platine de connexion, transversalement par rapport à la direction d'insertion.

2. Porte-modules suivant la revendication 1, caractérisé par le fait qu'il comporte une glissière (32) qui est dirigée transversalement par rapport à la direction d'insertion des modules (18,20,22) et est utilisée pour l'insertion de la platine de connexion.

3. Porte-modules suivant la revendication 1 ou 2, caractérisé par le fait qu'il comporte au moins deux étages superposés pour l'insertion de modules (18,20,22).

4. Porte-modules suivant la revendication 3, caractérisé par le fait qu'une platine commune de connexion (28) est associée à tous les étages.

5. Porte-modules suivant la revendication 3 ou 4, caractérisé par le fait qu'au moins entre deux étages équipés de modules électroniques et/ou électromécaniques (18,22) est prévu un étage servant à loger une unité formant ventilateur (20), qui peut être raccordée à la platine de connexion (28).

6. Porte-modules suivant la revendication 5, caractérisé par le fait qu'un circuit de commande électronique destiné à commander l'unité formant ventilateur (20) est disposé sur la platine de connexion (28).

7. Porte-modulez suivant la revendication 6, caractérisé par le fait qu'au moins des parties du circuit de commande électronique sont communes à toutes les unités formant ventilateurs (20).

8. Porte-modules suivant l'une des revendications 5 à 7, caractérisé par le fait qu'il comporte, sur son extrémité supérieure, une ouverture d'entrée d'air et, à proximité de son extrémité inférieure, une ouverture de sortie d'air.
